# EUROPEAN PATENT APPLICATION

(11) **EP 0 889 359 A2**
(43) Date of publication of application: **07.01.1999**
(21) Application number: 98305049.3
(22) Date of filing: 26.06.1998
(51) Int. Cl.: G03F 1/00, G03F 7/20, H01L 21/00

(54) **Etching method for manufacture of a phase-shift mask**

(30) Priority: 27.06.1997 JP 187377/97
(71) Applicant: CANON KABUSHIKI KAISHA, Tokyo (JP)
(72) Inventor: Tanaka, Ichiro, Ohta-ku, Tokyo (JP)
(74) Representative: Beresford, Keith Denis Lewis

(57) **Abstract**

An etching method includes a first step for carrying out an etching process to a workpiece, and a second step for detecting etching depth in relation to the workpiece, on the basis of an etching monitor disposed in substantially the same etching ambience as of the workpiece, wherein the second step is carried out as the first step is being interrupted.

## Description

### FIELD OF THE INVENTION AND RELATED ART

This invention relates to an etching method and apparatus suitably usable for manufacture of a phase shift mask in a semiconductor device exposure apparatus, a light wave guide and a diffractive optical element, for example. In another aspect, the invention is concerned with a diffractive optical element manufacturing method and apparatus.

When a reactive ion etching is to be performed on a SiO₂ film on a silicon wafer, for example, by using a flon (Freon) series gas, generally the emitted light intensity of fluorine atom is monitored and, on the basis of a phenomenon that the emitted light intensity changes as the silicon surface is exposed (uncovered), the completion is discriminated. "Technical Report of IEICE (Institute of Electronics, Information and Communication and Engineers)", SSD81-136, pages 37-43, reports that, by monitoring the quantities of CO⁺, CO₂ ⁺ and SiF₃ ⁺, for example, with use of a quadruple-pole mass analyzer, points of completion at interfaces of PSG, SiO₂ and Si can be detected.

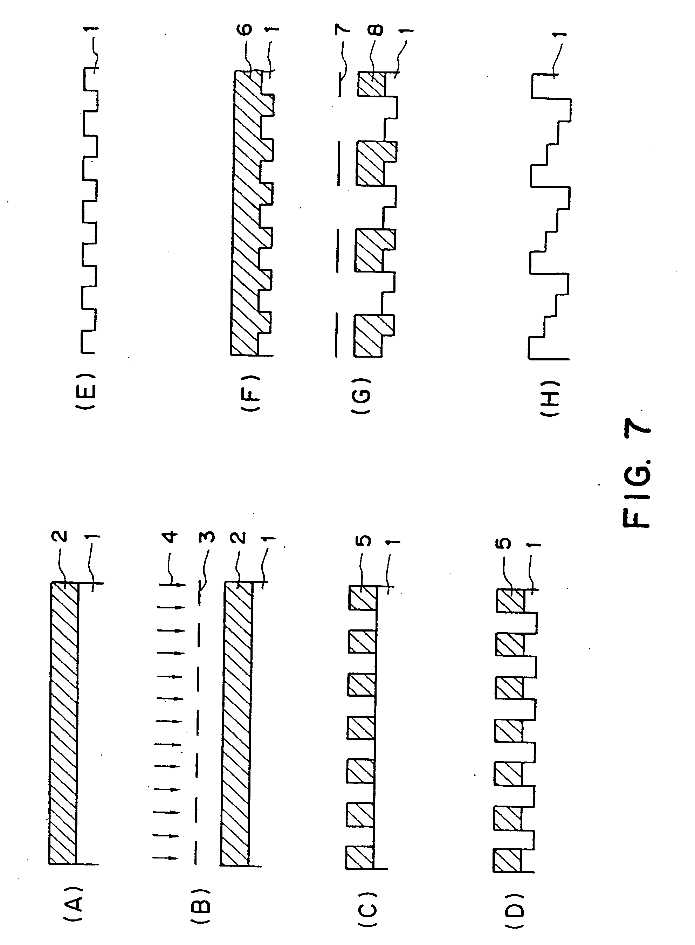

Japanese Laid-Open Patent Application, Laid-Open No. 72319/1995 or U.S. Patent No. 5,156,943 shows a method of producing a step-like structure wherein a resist is aligned as an etching mask. Figures 7A - 7H illustrate the procedure of manufacturing a diffractive optical element having step-like shape, by sequentially using double period masks.

In Figure 7A, a drop of resist is applied onto a clean substrate 1 and, by spin coating, the resist is formed into a thin film of about 1 micron. With baking treatment, a resist film 2 is produced. Subsequently, in Figure 7B, the substrate is loaded into an exposure apparatus (not shown) with which a desired finest diffraction pattern can be printed. Then, while using a reticle 3 having a desired diffraction pattern as a mask, exposure light 4 to which the resist has sensitivity is projected to the resist film 2. Where a positive type resist is used, as shown in Figure 7C, the region having been exposed with exposure light 4 becomes soluble to a development liquid. Thus, the pattern of reticle 3 is transferred to the resist film 2 to produce a pattern thereon, whereby a resist pattern 5 of desired size is produced.

Subsequently, in Figure 7D, the substrate 1 is loaded into an ion beam etching apparatus or a reactive ion etching apparatus capable of performing anisotropic etching, and while using the resist pattern 5 having been patterned as an etching mask, etching treatment is carried out to the substrate 1 for a predetermined time period. By this, it is etched to a desired depth. The resist pattern 5 is then removed, such that, as shown in Figure 7E, a pattern having two-level steps is produced on the substrate 1. In Figure 7F, again a resist film 6 is formed on the substrate 1 in a similar process as that of Figure 7A.

Subsequently, in Figure 7G, the substrate 1 is loaded into an exposure apparatus, and a reticle 7 having a diffraction pattern of a period twice the reticle 3 is used as a mask. More specifically, with respect to the pattern having been produced by the steps up to Figure 7E, alignment operation is made with an alignment precision of the exposure apparatus. After this, the resist film 6 is exposed with the reticle, and development process is carried out. By this, a resist pattern 8 is produced.

After this, dry etching is carried out similarly to the process of Figure 7D, and the resist pattern 8 is removed similarly to the process of Figure 7E. Thus, as shown in Figure 7H, a pattern 9 having four-level step structure is produced on the substrate 1. In this manner, a diffractive optical element with four-level step structure can be produced. By repeating similar processes additionally by using a double period mask, a diffractive optical element of eight-level step structure can be produced.

In the example of Figures 7A - 7H, however, since the emitted light intensity or ion quantity does not change in the neighbourhood of etching completion point during etching of a single material, it is difficult to detect the completion point.
Conventionally, therefore, the completion point is determined on the bases of fixed etching time. However, this involves inconveniences in respect to reproducibility, and it leads to dispersion of etching depth.

If there is dispersion of etching depth, the diffraction efficiency of diffractive optical element decreases which in turn leads to degradation of performance of an optical instrument in which the diffractive optical element is incorporated.

On the other hand, Japanese Laid-Open Patent Application, Laid-Open No. 90330/1997 shows a method of manufacturing a liquid crystal display device wherein a film thickness measuring pattern is provided in a peripheral portion of a glass substrate and wherein dry etching is carried out while measuring the reflection factor or polarization rate of the measuring pattern. In this method, the dry etching processed thickness is monitored on the basis of a change in measurement signal of the reflection factor or polarization rate of the measuring pattern, and as the thickness of the measuring pattern reaches a predetermined thickness, the dry etching is stopped.

In this method, however, since the reflection factor or polarization rate of the measuring pattern has to be measured during actual etching treatment, there may be an effect of plasma to the measurement result, and the etching depth monitoring may not be accurate.

### SUMMARY OF THE INVENTION

It is an object of the present invention to provide an etching method and/or apparatus by which the etching depth can be measured accurately and by which etching rate reproducibility is improved.

In accordance with an aspect of the present invention, there is provided an etching method, comprising: a first step for carrying out an etching process to a workpiece; and a second step for detecting etching depth in relation to the workpiece, on the basis of an etching monitor disposed in substantially the same etching ambience as of the workpiece; wherein said second step is carried out as said first step is being interrupted.

In accordance with another aspect of the present invention, there is provided an etching apparatus, comprising: a container for accommodating therein a workpiece and an etching monitor; and detecting means for detecting etching depth related to the workpiece, on the basis of cooperation with the etching monitor; wherein said detecting means detects the etching depth as the etching process to the workpiece is being interrupted.

These and other objects, features and advantages of the present invention will become more apparent upon a consideration of the following description of the preferred embodiments of the present invention taken in conjunction with the accompanying drawings.

### BRIEF DESCRIPTION OF THE DRAWINGS

Figure 1 is a schematic view of a reactive ion etching apparatus according to an embodiment of the present invention.

Figures 2A - 2F are schematic views, respectively, for explaining processes for manufacturing a diffractive optical element in accordance with an embodiment of the present invention.

Figure 3 is a schematic and sectional view of a diffractive optical element wherein an etching monitor is removed.

Figure 4 is a schematic view of a semiconductor exposure apparatus having a diffractive optical element.

Figure 5 is a perspective view of a diffractive optical element.

Figure 6 is a sectional view of a diffractive optical element.

Figures 7A - 7H are schematic views, respectively, of conventional diffractive optical element manufacturing processes.

Figure 8 is a flow chart of semiconductor device manufacturing processes.

Figure 9 is a flow chart for explaining details of a wafer process in the procedure of Figure 8.

### DESCRIPTION OF THE PREFERRED EMBODIMENTS

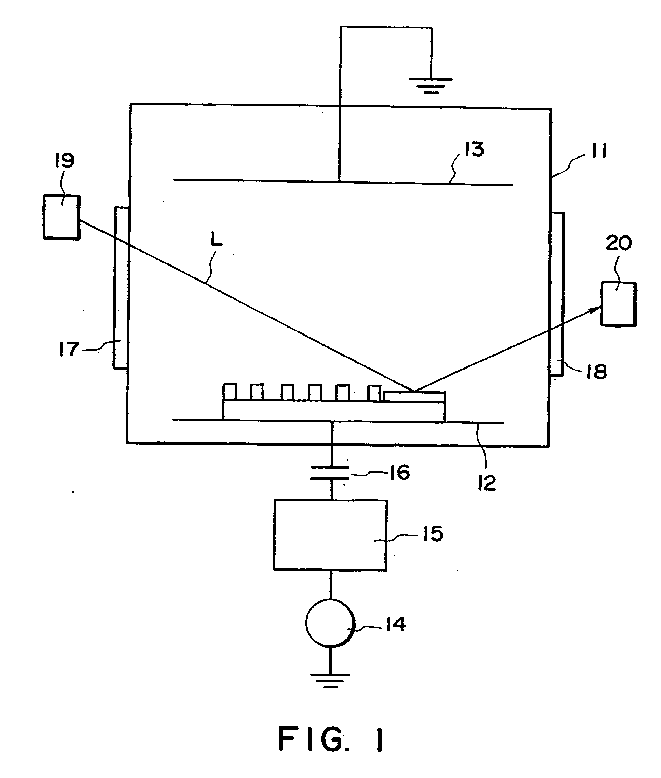

The present invention will be described in detail with reference to preferred embodiments and in conjunction with Figures 1 - 6.

Figure 1 shows the structure of a reactive ion etching apparatus wherein a flat cathode 12 and a flat anode 13 are disposed in parallel to each other, within a vacuum container 11. A high frequency voltage source 14 is connected to this cathode 12 through a matching box 15 and a blocking capacitor 16. A sample to which an ion etching process is to be made can be placed on the cathode 12. Also, the vacuum container 11 and the anode 13 are grounded. There are glass windows 17 and 18 of light transmissivity which are formed at side faces of the vacuum container. Disposed outside the glass windows 17 and 18 are a light source portion 19 and a light receiving portion 20 of an ellipsometer (film thickness measuring means). This film thickness measuring means measures the film thickness of a transmissive layer of etching monitor means, to be described, to thereby indirectly detect the etching depth of a workpiece.

As the film thickness measuring means, an optical film thickness measuring device of interference type may be used. The light beam of the ellipsometer goes along a path L. The incidence angle and the detection angle can be changed as desired in accordance with the thickness to be measured. Further, in order to intercept plasma light emission, a filter for blocking light other than the light beam can be inserted as required.

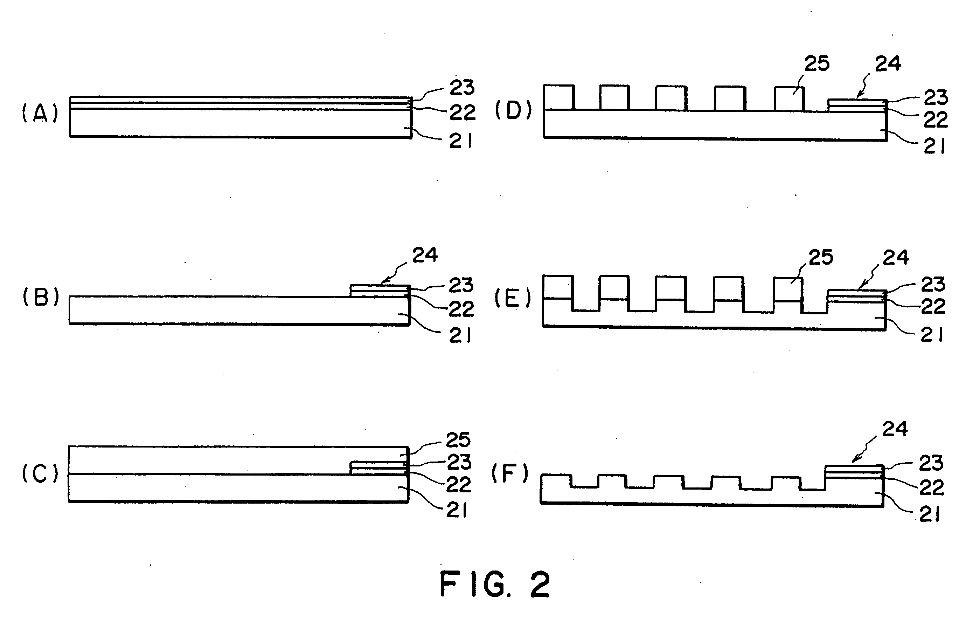

Next, the etching process using the apparatus of Figure I will be explained with reference to an example of diffractive optical element manufacturing procedure and in conjunction with Figure 2.

First, on a substrate 21 of quartz SiO₂ of a thickness lmm, a chromium film (reflective film) 22 of 100 nm thickness is formed in accordance with a sputtering method. Subsequently, on this film, SiO₂ film (transmissive film) 22 of the same material as the substrate 21 is formed to a thickness of for example 1 micron, i.e. a thickness which is larger than a design etching depth for the substrate. This is the state illustrated i Figure 2A. Subsequently, the portion which will serve as etching monitor means 24 is covered by a photoresist pattern (not shown), and unnecessary SiO₂ film 23 is removed by dray etching. Thereafter, the chromium film 22 is etched. The result is shown in Figure 2B.

In Figure 2C, a photoresist 25 is applied to the substrate in accordance with spin coating method, and thereafter, a desired pattern is printed by exposure onto the substrate by use of a stepper and the substrate is then developed. This procedure is made so that no photoresist 25 remains at the portion that provides the etching monitor means 24. The resultant state is shown in Figure 2D.

The substrate 21 in this state is loaded on the cathode 12 of the reactive ion etching apparatus of Figure 1, and ion etching of 100 nm, for example, is carried out while using the photoresist 25 as a mask. Here, the ion etching maybe made with the following etching conditions inside the vacuum chamber 11, i.e., CF₄ gas flow rate: 20 cm³/min.; H₂ gas flow rate: 6 cm³/min.; pressure during etching: 4 Pa; and high frequency voltage: 60 W, for example.

The possibility of adverse effect of plasma upon ellipsometer is taken into account in this embodiment, and during film thickness measurement the high frequency voltage source 14 is turned off just for a moment and, during that period, the film thickness measurement is made automatically. Then, the data of total reduction in film thickness of SiO₂ film 23 from the start of etching to predetermined time is compared with memorized data of designed etching depth, and discrimination is made as to whether the etching should be continued or not. The etching process is repeated until the predetermined etching depth is reached.

In the example described above, average etching time of ten etching operations was about 10 minutes. It is to be noted that a mechanism may be added by which an etching stopping signal may be outputted from the ellipsometer so that the high frequency voltage source 14 may be stopped automatically.

Variation of depth in the ten etching operations was ±3% (3σ). In a comparative test, the etching time was set at ten minutes and the etching operation was made ten times. Dispersion of depth in that case was ±14% (3σ). Thus, it is seen that, with this embodiment of the present invention, the etching rate reproducibility is improved significantly.

Figure 2E shows the state in which ion etching has been completed. Then, by using oxygen ashing or resist removing liquid, the photoresist 25 is removed. Then, a diffractive optical element such as shown in Figure 2F is accomplished.

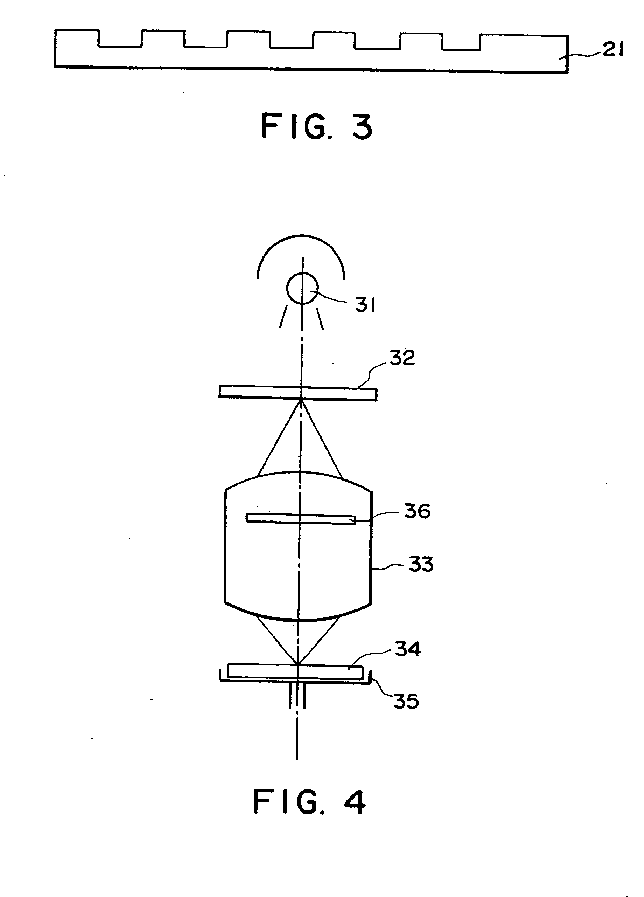

If the etching monitor means 24 is not necessary, a lithographic process may be made additionally. That is, while selecting only the etching monitor portion 24, the SiO₂ film 23 and chromium film 22 may be removed. Then, a diffractive optical element such as shown in Figure 3 can be produced.

While the above embodiment has been described with reference to an example of etching for a diffractive optical element, this method may be applied to manufacture of elements based on etching process, such as a phase shift mask or a light wave guide, for example.

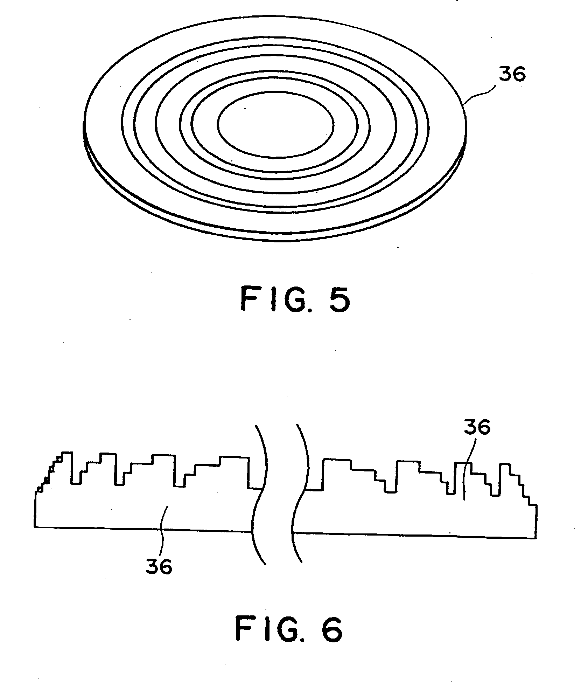

Figure 4 shows the structure of an embodiment wherein a diffractive optical element having been produced in accordance with the method described hereinbefore is incorporated into a semiconductor exposure apparatus (stepper) which uses i-line rays or KrF ultraviolet rays, for example. The stepper comprises an illumination optical system 31 for use with exposure light of a wavelength 248 nm, a reticle 32 having a predetermined pattern, an imaging optical system 25 having a reduction magnification 1/5, and a wafer stage 35 for carrying a semiconductor substrate 34 thereon. The imaging optical system 33 is provided with a diffractive optical element 36 having an optical function similar to that of a convex lens, for reduction of chromatic aberration and for aspherical surface effect. Figure 5 is a perspective view of the diffractive optical element 36, and Figure 6 is a sectional view of the diffractive optical element 36. In Figure 6, the grating section of one period of the diffractive optical element 36 has a four-level step structure. This is merely for convenience in illustration and, actually, the diffractive optical element 36 has an eight-level step structure.

Light from the illumination optical system 31 serves, through the function of the imaging optical system 33, to image the pattern of the reticle 32 upon the semiconductor substrate 34 held on the wafer stage 35, in a reduced scale of 1/5. In the diffractive optical element 36 of eight-level step structure, a target value of each step difference (level difference) is 61 nm, and the width of the outermost circumferential step is 0.35 micron. The diameter of the diffractive optical element 36 is 120 mm.

Light impinging on this step-like diffractive optical element 36 is transmitted therethrough, while being divided mainly into diffraction lights of first order, ninth order and seventeenth order.
Idealistically, there occurs no zero-th order light (non-diffraction light). However, the more the etching depth deviates from a target value, the more the zero-th order light produced.

If this diffractive optical element 36 having steps of eight levels, an outermost peripheral step width of 0.35. micron and a diameter of 120 mm, is produced in accordance with conventional method and under the state in which the etching depth deviates largely from 61 nm, 'zero-th order non-diffraction light will be produced by use of such diffractive optical element 36. Such unwanted light will provide a false pattern upon the image plane, and the image quality will be degraded largely. On the other hand, such problem does not arise if the optical element is manufactured in accordance with this embodiment of the present invention. That is, a diffractive optical element 36 of high diffraction efficiency can be accomplished, and an optical instrument such as a stepper having high imaging performance can be provided.

In accordance with the etching method having been described with reference to these embodiments, the etching depth can be detected with good precision and the etching rate reproducibility is improved significantly. Particularly, a diffractive optical element can be manufactured with good precision.

Further, in an etching apparatus according to these embodiment of the present invention, during interruption of electric discharge, reduction of film thickness due to etching is compared with an etching depth memorized beforehand, and the etching process is continued while automatically reproducing the etching depth. As a result, even if the etching is stopped in the course of the process, an element having uniform performance can be produced. This effectively increases the yield.

Next, an embodiment of semiconductor device manufacturing method which uses an exposure apparatus such as shown in Figure 4, will be explained.

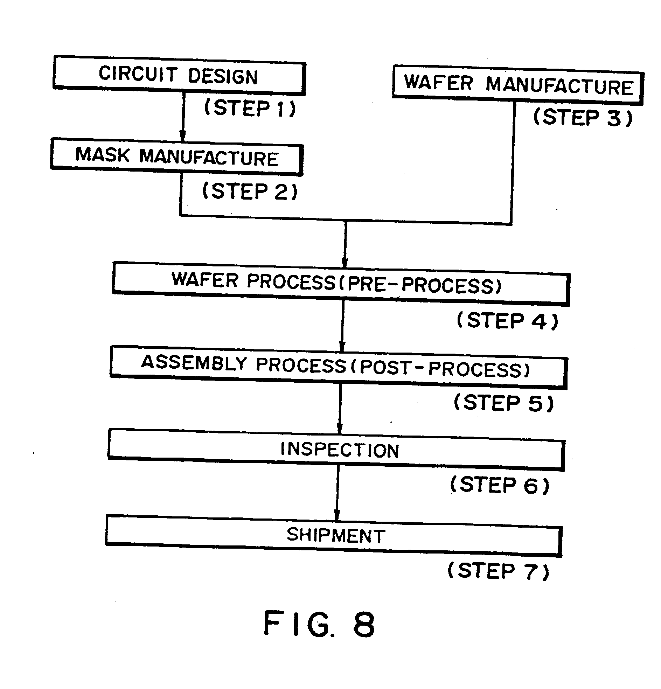

Figure 8 is a flow chart of procedure for manufacture of microdevices such as semiconductor chips (e.g. ICs or LSIs), liquid crystal panels, or CCDs, for example. Step I is a design process for designing a circuit of a semiconductor device. Step 2 is a process for making a mask on the basis of the circuit pattern design. Step 3 is a process for preparing a wafer by using a material such as silicon. Step 4 is a wafer process which is called a preprocess wherein, by using the so prepared mask and wafer, circuits are practically formed on the wafer through lithography. Step 5 subsequent to this is an assembling step which is called a post-process wherein the wafer having been processed by step 4 is formed into semiconductor chips. This step includes assembling (dicing and bonding) process and packaging (chip sealing) process. Step 6 is an inspection step wherein operation check, durability check and so on for the semiconductor devices provided by step 5, are carried out. With these processes, semiconductor devices are completed and they are shipped (step 7).

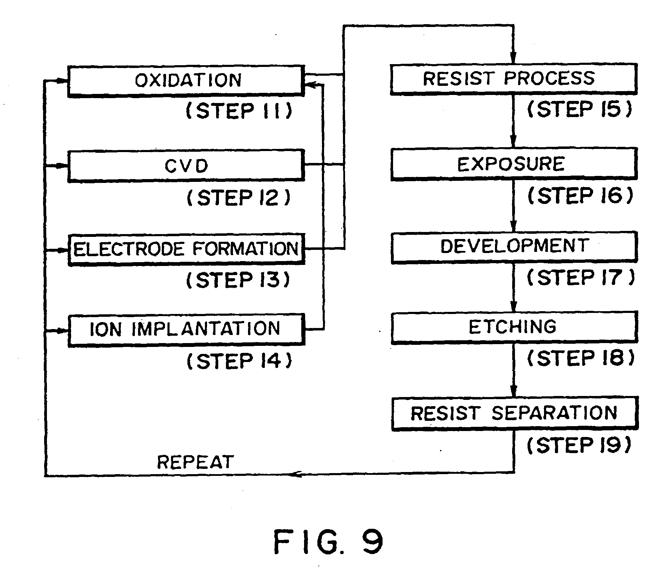

Figure 9 is a flow chart showing details of the wafer process. Step 11 is an oxidation process for oxidizing the surface of a wafer. Step 12 is a CVD process for forming an insulating film on the wafer surface. Step 13 is an electrode forming process for forming electrodes upon the wafer by vapor deposition. Step 14 is an ion implanting process for implanting ions to the wafer. Step 15 is a resist process for applying a resist (photosensitive material) to the wafer. Step 16 is an exposure process for printing, by exposure, the circuit pattern of the mask on the wafer through the exposure apparatus described above. Step 17 is a developing process for developing the exposed wafer. Step 18 is an etching process for removing portions other than the developed resist image. Step 19 is a resist separation process for separating the resist material remaining on the wafer after being subjected to the etching process. By repeating these processes, circuit patterns are superposedly formed on the wafer.

With these processes, high density microdevices can be manufactured.

While the invention has been described with reference to the structures disclosed herein, it is not confined to the details set forth and this application is intended to cover such modifications or changes as may come within the purposes of the improvements or the scope of the following claims.

## Claims

1. An etching method, comprising:
a first step for carrying out an etching process to a workpiece; and
a second step for detecting etching depth in relation to the workpiece, on the basis of an etching monitor disposed in substantially the same etching ambience as of the workpiece;
wherein said second step is carried out as said first step is being interrupted.

2. A method according to Claim 1, wherein the etching monitor includes a reflective layer and a transmissive layer disposed on the reflective layer, wherein a change in the transmissive layer is measured on the basis of light reflected at the etching monitor, and wherein the etching depth related to the workpiece is determined on the basis of the measurement.

3. A method according to Claim 1, further comprising a third step for comparing the etching depth as detected at said second step with a predetermined etching depth memorized beforehand, and a fourth step for stopping the etching process as the etching depth detected at said second step is substantially in consistency with the predetermined etching depth.

4. A method according to Claim 1, wherein the transmissive layer has a thickness larger than the predetermined etching depth.

5. A method according to Claim 1, wherein the workpiece and the transmissive layer are made of the same material.

6. A method according to Claim 1, wherein the etching monitor is provided on the workpiece.

7. A method according to Claim 1, wherein the etching process includes a reactive ion etching process.

8. An etching apparatus, comprising:
a container for accommodating therein a workpiece and an etching monitor; and
detecting means for detecting etching depth related to the workpiece, on the basis of cooperation with the etching monitor;
wherein said detecting means detects the etching depth as the etching process to the workpiece is being interrupted.

9. An apparatus according to Claim 8, wherein the etching monitor includes a reflective layer and a transmissive layer disposed on the reflective layer, wherein said detecting means measures a change in the transmissive layer on the basis of light reflected at the etching monitor, and wherein the etching depth related to the workpiece is determined on the basis of the measurement.

10. An apparatus according to Claim 8, further comprising storing means for memorizing a predetermined etching depth therein, wherein the etching process is stopped as the etching depth detected is substantially in consistency with the predetermined etching depth.

11. An element manufacturing method, comprising:
a first step for carrying out an etching process to a substrate; and
a second step for detecting etching depth in relation to the substrate, on the basis of an etching monitor disposed in substantially the same etching ambience as of the substrate;
wherein said second step is carried out as said first step is interrupted.

12. A method according to Claim 11, wherein the etching monitor includes a reflective layer and a transmissive layer disposed on the reflective layer, wherein a change in the transmissive layer is measured on the basis of light reflected at the etching monitor, and wherein the etching depth related to the substrate is determined on the basis of the measurement.

13. A method according to Claim 11, wherein the substrate includes a quartz substrate.

14. A method according to Claim 11, wherein the element to be manufactured is a diffractive optical element.

15. An element manufacturing method, comprising the steps of:
forming an etching mask on a substrate; and
performing an etching process to the substrate in accordance with the procedure as recited in any one of Claims 1 - 7.

16. A diffractive optical element, comprising:
a surface step structure provided on a substrate and having a predetermined period, wherein the surface step structure has been formed in accordance with the procedure as recited in any one of Claims 11 - 15.

17. An optical instrument, comprising a diffractive optical element as recited in Claim 16.

18. An exposure apparatus, comprising:
an illumination optical system for illuminating a pattern formed on a reticle; and
a projection optical system for projecting the pattern onto a wafer;
wherein at least one of said illumination optical system and said projection optical system includes a diffractive optical element as recited in Claim 16.

19. A device manufacturing method, comprising the steps of:
coating a substrate with a photosensitive material;
lithographically transferring a pattern onto the substrate by use of an exposure apparatus as recited in Claim 18; and
developing the substrate.

20. A method of etching a workpiece by a predetermined amount, wherein the workpiece comprises a monitor region having a thickness equal to or greater than the predetermined amount comprising the steps of:
etching the substrate and monitor region for a first interval;
suspending etching and measuring the thickness of the remaining monitor region;
determining the amount of thickness reduction of the monitor region;
comparing the thickness reduction with the predetermined amount; and
continuing or terminating etching on the basis of the comparison result.

21. A method according to claim 2, wherein a reflective layer underlies the monitor region, and the thickness of the monitor region is measured on the basis of light reflected from the reflective layer.
